Europäisches Patentamt

**European Patent Office**

**Office européen des brevets**

(11) Numéro de publication: **0 229 547 B1**

(12) **FASCICULE DE BREVET EUROPEEN**

(45) Date de publication de fascicule du brevet: **05.08.92**

(51) Int. Cl.⁵: **H02H 7/26**, H02H 3/26, G01R 29/16

(21) Numéro de dépôt: **86402622.4**

(22) Date de dépôt: **26.11.86**

(54) Procédé et dispositif de discrimination d'un conducteur en défaut dans une ligne multiple.

(30) Priorité: **04.12.85 FR 8517914**

(43) Date de publication de la demande:
**22.07.87 Bulletin 87/30**

(45) Mention de la délivrance du brevet:
**05.08.92 Bulletin 92/32**

(84) Etats contractants désignés:
**CH DE FR GB IT LI SE**

(56) Documents cités:
**FR-A- 547 760**
**FR-A- 563 498**
**FR-A- 679 137**
**US-A- 4 513 340**

(73) Titulaire: **SCHLUMBERGER INDUSTRIES**
**50, avenue Jean Jaurès**
**F-92120 Montrouge(FR)**

(72) Inventeur: **Heller, Isabelle**
**5, rue Charles Desvergnes**
**F-92190 Meudon(FR)**

(74) Mandataire: **Weinmiller, Jürgen et al**
**Lennéstrasse 9 Postfach 24**
**W-8133 Feldafing(DE)**

Rank Xerox (UK) Business Services

## Description

La présente invention concerne un procédé et un dispositif pour déterminer à quel groupe polyphasé de conducteurs appartient un conducteur affecté par un défaut se manifestant sur une phase d'une ligne électrique à au moins deux groupes polyphasés dont les phases correspondantes sont reliées en parallèle à au moins une extrémité de la ligne.

L'accroissement important de la consommation d'énergie a conduit depuis quelques années à mettre en place des lignes électriques doubles, ou à doubler les lignes existantes, dans le but d'assurer le transport de puissances électrique plus importantes.

Ces lignes doubles comportent, dans le case d'énergie triphasée, deux groupes (appelés "ternes") de trois conducteurs dont chacun est assigné à une phase, les phases correspondantes des deux ternes étant susceptibles d'être reliées en parallèle au moins à une extrémité de la ligne et généralement reliées en parallèle des deux côtés de la ligne.

Ces lignes doubles peuvent être le siège de défauts simultanés sur des phases des deux groupes ou ternes en un même point.

Jusqu'à présent, les dispositifs de protection de ligne, conçus pour la protection de lignes simples, c'est-à-dire généralement de lignes à un seul terne, n'étaient pas en mesure de prendre en compte la possibilité de tels défauts. propres aux lignes multiples.

Aussi, les procédés classiques d'identification de phase en défaut, tels que celui décrit par le brevet US 3 626 281 ou le brevet US 4 366 474, bien que donnant toute satisfaction pour la protection de lignes simples, peuvent-ils conduire à des résultats indésirables dans le cas de lignes multiples.

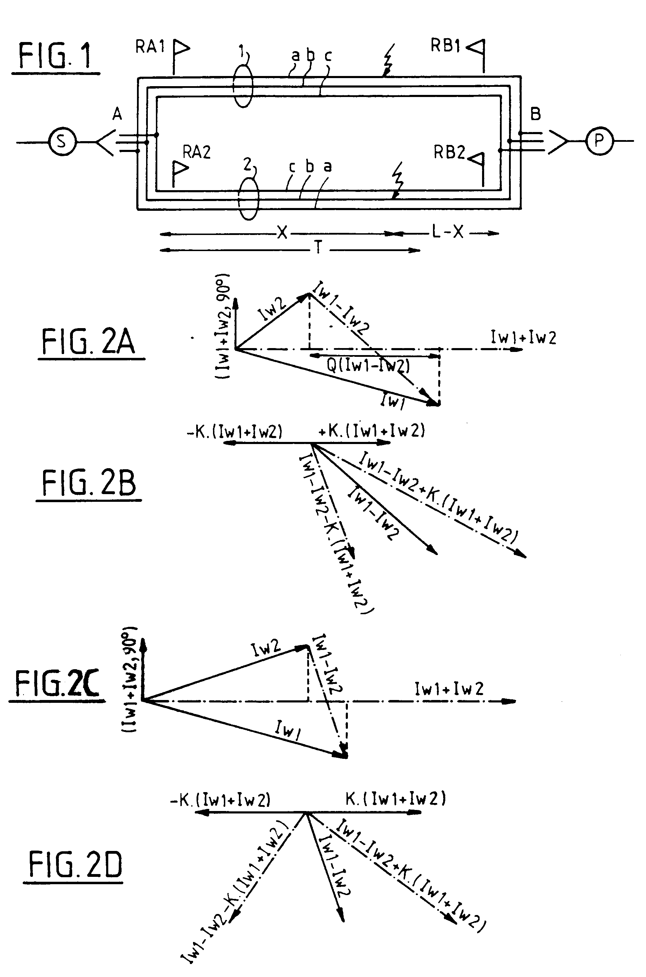

En particulier, si l'on se réfère à la figure 1, dans le cas de lignes doubles triphasées, c'est-à-dire comportant deux groupes 1 et 2 (ternes) de trois conducteurs affectés aux phases a, b, c, respectives et reliés en parallèle aux extrémités de la ligne, deux dispositifs de protection sont disposés, à chacune des extrémités de la ligne, sur les ternes respectifs 1 et 2.

Si un défaut se produit entre le conducteur a1 assigné à la phase a dans le terne 1 et le conducteur b2 assigné à la phase b dans le terne 2, les phases a et b sont globalement vues en défaut, de sorte que les conducteurs a1, b1 d'une part et a2, b2 d'autre part sont indistinctement considérés comme étant en défaut, ce qui peut conduire à mettre la ligne hors service; or un tel déclenchement est indésirable dans la mesure où, les conducteurs b1 et a2 étant sains, c'est-à-dire non affectés par le défaut, la ligne pourrait être gardée en service grâce aux conducteurs a2, b1, c1 et c2.

D'autre part, le manque d'information sur l'identité du conducteur en défaut peut conduire à des erreurs dans la détection d'autres paramètres du défaut, en particulier dans la détermination de la direction indiquant l'origine du défaut.

Dans ce contexte, le but de la présente invention est précisément de proposer des moyens pour discriminer les conducteurs sains et les conducteurs en défaut dans une ligne multiple, c'est-à-dire dans une ligne comprenant plusieurs groupes polyphasés de conducteurs, de manière notamment à pouvoir continuer à utiliser les conducteurs qui, bien qu'assignés à une phase globalement vue en défaut, ne sont pas eux-mêmes touchés par ce défaut.

Le document US-A-4 513 340 décrit un procédé pour déterminer à quel groupe polyphasé de conducteurs appartient un conducteur affecté par un défaut se manifestant sur une phase d'une ligne électrique à deux groupes polyphasés dont les phases correspondantes sont susceptibles d'être reliées en parallèle à au moins une extrémité de la ligne. Ce procédé est basé sur une commande de relais disposés respectivement dans les deux conducteurs de ce groupe, à partir de la somme et de la différence des courants dans ces conducteurs, et de façon à ce que, dans le cas où l'un des conducteurs est en défaut, la phase relative entre cette somme et cette différence soit en opposition d'un conducteur à l'autre, afin de ne commander que le relais associé au conducteur en défaut. Ce procédé est donc limité à la détection d'un conducteur en défaut parmi deux et ne permet pas en particulier de détecter les deux conducteurs, ou plus généralement l'ensemble des conducteurs d'un groupe, simultanément en défaut.

La présente invention a pour objet un procédé permettant d'éviter cet inconvénient.

La présente invention a pour objet un procédé pour déterminer à quel groupe polyphasé de conducteurs appartient un conducteur affecté par un défaut se manifestant sur une phase d'une ligne électrique à au moins deux groupes polyphasés dont les phases correspondantes sont reliées en parallèle à une extrémité de la ligne au moins, comprenant les opérations consistant à :

- recueillir, en un point de mesure de la ligne, des premier et second signaux de courants proportionnels aux valeurs instantanées des courant circulant dans des premier et second conducteurs qui, respectivement dans les premier et second groupes, sont les conducteurs assignés à la phase vue en défaut,
- élaborer des signaux de traitement représentés par des combinaisons des premier et second signaux de courant,

- effectuer une opération évoluée de comparaison consistant à ou équivalent à comparer à un seuil de valeur déterminée une grandeur de dissymétrie exprimable comme une fonction desdits signaux de traitement et représentative de la dissymétrie de la répartition, entre les premier et second conducteurs, du courant de la phase en défaut, et

- élaborer au moins un premier signal de sortie identifiant comme sain le conducteur associé au signal de courant ayant le plus faible module, sous réserve que ladite grandeur de dissymétrie dépasse, en valeur absolue, ledit seuil de valeur déterminée.

La présente invention a pour objet un tel procédé, essentiellement caractérisé en ce que ladite grandeur de dissymétrie est proportionnelle au produit, par le cosinus de l'angle de phase entre la différence et la somme des premier et second signaux de courant, du rapport du module de la différence de ces signaux de courant au module de leur somme.

Pour cela, l'élaboration des signaux de traitement comprend par exemple l'élaboration d'un premier signal de traitement fonction de la différence des premier et second signaux de courant, et l'élaboration d'un second signal de traitement fonction de la somme des premier et second signaux de courant.

Plus précisément, ce procédé comprend généralement l'élaboration de premier et second signaux de sortie identifiant, respectivement au premier et second conducteur, ou inversement, le conducteur sain et le conducteur affecté par le défaut, selon que ladite grandeur de dissymétrie est négative, ou positive, sous réserve que cette grandeur soit, en valeur absolue, supérieure audit seuil déterminé.

Le procédé peut en outre comprendre l'élaboration d'un troisième signal de sortie identifiant les deux conducteurs comme étant tous deux affectés par le défaut si ladite grandeur de dissymétrie est, en valeur absolue, inférieure audit seuil déterminé.

L'opération évoluée de comparaison comprend par exemple d'une part l'élaboration d'au moins un premier signal mixte proportionnel à la différence du premier signal de traitement et du produit de ladite valeur de seuil avec le second signal de traitement, et d'autre part au moins une première opération élémentaire de comparaison consistant essentiellement à comparer les polarités respectives de ce premier signal mixte et du second signal de traitement.

L'opération évoluée de comparaison peut en outre comprendre d'une part l'élaboration d'un second signal mixte proportional à la somme du premier signal de traitement et du produit de ladite valeur de seuil avec le second signal de traitement, et, d'autre part, une seconde opération élémentaire de comparaison consistant essentiellement à comparer les polarités respectives du second signal mixte et du second signal de traitement.

Dans ce procédé, appliqué à la protection d'un tronçon de ligne dont la longueur est représentée par une fraction de la longueur totale de la ligne, et qui est situé en aval du point de mesure et en amont d'un point de limite de protection, le seuil est de préférence choisi, en valeur absolue, comme étant sensiblement égal au rapport d'une première grandeur représentée par le complément à "1" de ladite fraction de longuer totale de ligne, à une seconde grandeur représentée par le pourcentage, par rapport à l'impédance totale de la ligne et des sources auxquelles elle est reliée, de l'impédance située en aval du point de limite de protection.

Dans un mode de réalisation avantageux, le procédé comprend l'élaboration, en tant que signaux de traitement, de premier et second signaux de courant de transition dont chacun est, à chaque instant, proportionnel à la différence entre la valeur à cet instant du signal de courant correspondant et la valeur qu'aurait en ce signal de courant au même instant en l'absence de défaut.

Dans le cas où les signaux de traitement varient au cours d u temps en fonction des valeurs instantanées de module et d'angle de phase des premier et second signaux de courant, ladite opération évoluée de comparaison est effectuée à un instant où le second signal de traitement passe par un extremum.

Cependant, dans un autre mode de réalisation, le procédé de l'invention peut aussi comprendre l'élaboration en tant que premier et second signaux de traitement, de signaux scalaires de traitement qui ne varient au cours du temps qu'en fonction du module des premier et second signaux de courant.

Le procédé pour déterminer à quels ternes respectifs appartiennent des conducteurs affectés par des défauts se manifestant sur au moins deux phases d'une ligne électrique à deux ternes dont les phases correspondantes sont reliées en parallèle, consiste de préférence à mettre en oeuvre, pour chacune des phases en défaut, le procédé précédemment décrit.

Le dispositif de l'invention comprend :

- des moyens de combinaison pour élaborer des signaux de traitement représentés par des combinaisons de premier et second signaux de courant, ces derniers étant proportionnels aux valeurs instantanées des courants circulant dans des premier et second conducteurs qui, respectivement dans les premier et second groupes, sont les conducteurs assignés à la phase vue en défaut,

- des moyens pour effectuer une opération évoluée de comparaison consistant à ou équivalant à comparer à un seuil de valeur déterminée une grandeur de dissymétrie exprimable comme une fonction desdits signaux de traitement et représentative de la dissymétrie de la répartition, entre les premier et second conducteurs, de courant de la phase en défaut, et

- des moyens pour élaborer au moins un premier signal de sortie identifiant comme sain le conducteur associé au signal de courant ayant le plus faible module, sous réserve que ladite grandeur de dissymétrie dépasse, en valeur absolue, ledit seuil de valeur déterminée, et est essentiellement caractérisé en ce que ladite grandeur de dissymétrie est proportionnelle au produit, par le cosinus de l'angle de phase entre la différence et la somme des premier et second signaux de courant, du rapport du module de la différence de ces signaux de courant au module de leur somme.

Les moyens pour élaborer des signaux de traitement comprennent généralement des moyens pour élaborer un premier signal de traitement fonction de la différence des premier et second signaux de courant, et des moyens pour élaborer un second signal de traitement fonction de la somme des premier et second signaux de courant.

Quelques modes particuliers de réalisation de l'invention seront décrits ci-après à titre indicatif et nullement limitatif, en référence aux dessins annexés, parmi lesquels :

- la figure 1 représente une ligne double triphasée,
- les figures 2A et 2D, constituant ensemble la figure 2, sont des représentations vectorielles de signaux électriques intervenant dans le procédé et le dispositif de l'invention,
- la figure 3 est un schéma d'un dispositif correspondant à un premier mode de réalisation de l'invention,
- la figure 4 est un schéma d'un dispositif correspondant à un second mode de réalisation de l'invention,
- la figure 5 est un schéma d'un dispositif correspondant à un troisième mode de réalisation de l'invention, utilisable dans un cas particulier, et
- la figure 6 est un schéma d'un dispositif correspondant à un quatrième mode de réalisation de l'invention voisin du mode de réalisation de la figure 5, mais utilisable dans le cas général.

La ligne électrique de la figure 1 comporte deux ternes 1 et 2, c'est-à-dire deux groupes polyphasés 1 et 2 de conducteurs, qui relient en parallèle les deux extrémités A et B de la ligne, et dont chacun est assigné à l'une des phases d'un ensemble de trois phases électriques a, b et c.

La ligne est, à ses extrémités A et B respectives, reliée aux sources électriques triphasées S et P, présentant des impédances respectives $Z_s$ et $Z_p$.

Des dispositifs de protection, ou relais, RA1, RA2, RB1 et RB2 sont prévus sur la ligne aux deux extrémités A, B et sur les deux ternes 1 et 2 de celle-ci.

Ces relais peuvent être de type connu et mettre en oeuvre notamment les inventions protégées par les brevets américains US 3 626 281 ou US 4 366 474.

En particulier, ces relais élaborent et utilisent des signaux de courant et de tension qui, aux points de mesure correspondant à l'emplacement de ces relais sur la ligne, donnent une image de l'état électrique de cette dernière.

Ainsi, les relais RA1 et RA2 délivrent ensemble trois signaux de tension $V_a$, $V_b$, $V_c$ correspondant aux potentiels respectifs des phases a, b et c à l'extrémité A de la ligne, et délivrent en outre chacun trois signaux de courant, à savoir $I_{a1}$, $I_{b1}$, $I_{c1}$ pour RAI et $I_{a2}$, $I_{b2}$, $I_{c2}$ pour RA2, proportionnels aux valeurs instantanées des courants circulant, à l'extrémité A de la ligne, respectivement dans les ternes 1 et 2.

Les relais RB1 et RB2 délivrent et utilisent des signaux homologues relatifs à l'extrémité B de la ligne.

Gâce à ces signaux, ou au moins à certains d'entre eux, les relais RA1, RA2, RB1 et RB2 peuvent, en cas de défaut sur la ligne, déterminer globalement la ou les phases affectée(s) par le défaut. Par exemple, en cas de défaut entre les conducteurs $a_1$ et $b_2$, les relais RA1 et RA2 verront globalement les phases a et b en défaut.

Le but de la présente invention est de proposer des moyens pour discriminer, parmi les conducteurs assignés à une même phase en défaut, celui qui est sain (s'il existe) de celui qui est en défaut, de manière, par exemple dans le cas d'un défaut $a_1$ $b_2$, à garder les conducteurs $b_1$ et $a_2$ en service.

Sur la figure 2, l'indice w désigne une phase en défaut, qui peut donc être la phase a, la phase b ou la phase c (c'est-à-dire w = a, b, c), et les indices 1 et 2 désignent les ternes. Par conséquent, $w_1$ par exemple désigne le conducteur qui dans le terne 1, est affecté à la phase w qui se trouve en défaut; d'autre part, les signaux désignés par Iw1 et Iw2 sont les signaux de courant relatifs à la phase w vue en défaut et correspondant respectivement aux ternes 1 et 2. Par exemple, en cas de défaut $a_1 b_2$, conduisant notamment les relais RA1 et RA2 à voir les phases a et b en défaut, le signal Iw1 peut être le signal de courant $Ia_1$ utilisé par le

relais RA1 (ou le signal $I_{b1}$), et le signal Iw2 peut être le signal de courant $I_{a2}$ utilisé par le relais RA2 (ou le signal $I_{b2}$).

Les signaux Iw1 et Iw2 sont supposés disponibles en un même point, soit que les relais RA1 et RA2 sont physiquement très proches ou confondus, soit que l'un au moins de ces deux signaux est transmis à un endroit où l'autre signal est disponible.

Les signaux de Iw1 et Iw2 étant proportionnels aux valeurs instantanées des courants circulant respectivement dans les conducteurs w1 et w2 de la ligne, évoluent au cours du temps en fonction des valeurs instantanées respectives de module et d'angle de phase de ces courants.

Pour cette raison, les signaux de courant Iw1 et Iw2, ainsi que certains autres signaux dont la description suit, sont représentés sur la figure 2 sous forme de vecteurs.

Il paraît utile, pour une meilleure compréhension de l'invention, de rappeler ici les principes et le bien-fondé d'une telle repésentation vectorielle, largement utilisée par l'homme de l'art.

Les grandeurs périodiques, et plus particulièrement les grandeurs sinusoïdales telles que les courants de ligne et les signaux de courant Iw1 et Iw2, peuvent être caractérisés par un module M (appelé aussi amplitude), une fréquence F, et un angle de phase initial p.

A tout instant t, une telle grandeur périodique prend la valeur :
M.cos(2.PI.F.t + p) où cos désigne la fonction cosinus et où PI = 3.14159.

Une telle grandeur est ainsi égale à tout moment à la composante, suivant un axe horizontal appelé axe des réels, d'un vecteur de module M (représenté par la longueur de ce vecteur), faisant à l'instant initial (c'est-à-dire à t = o) un angle p avec l'axe des réels, et tournant avec une fréquence F autour de son origine, dans le sens contraire des aiguilles d'une montre.

On appelle "valeur instantanée d'angle de phase" l'angle 2.PI.F.t + p que fait ce vecteur avec l'axe des réels à l'instant t considéré.

On appelle "polarité" ou "signe" de la grandeur périodique, le signe de la fonction cos-(2.PI.F.t + p) à l'instant considéré.

Cette grandeur périodique a donc une polarité positive ou négative selon que le vecteur qui la représente pointe vers l'est ou vers l'ouest à l'instant considéré.

Enfin on appelle "mesure algébrique d'un vecteur" le produit de son module par sa polarité, et on appelle "projection d'un vecteur sur une direction déterminée" la mesure algébrique du vecteur parallèle à cette direction, ayant même orientation que le vecteur à projeter, et dont le module est égal au produit du module du vecteur à projeter par le cosinus de l'angle formé entre le vecteur à projeter et ladite direction.

Pour des raisons évidentes de commodité, les mêmes notations seront utilisées, dans la présente description, pour désigner les signaux considérés en tant que grandeur physiques et les vecteurs qui servent à les représenter.

Les courant dans les ternes 1 et 2 ayant même fréquence, l'angle que font entre eux les vecteurs Iw1 et Iw2 de la figure 2 est constant au cours du temps.

En plus des signaux de courant Iw1 et Iw2, la figure 2 fait apparaître des signaux Iw1-Iw2 et Iw1 + Iw2 qui seront respectivement désignés ci-après comme premier et second signaux de traitement.

Bien qu'en l'occurence ces premier et second signaux de traitement Iw1-Iw2 et Iw1 + Iw2 soient représentés par des combinaisons linéaires des signaux de courant Iw1, et Iw2, cette caractéristique n'est pas nécessaire pour la mise en oeuvre de l'invention.

Par exemple, ces signaux de traitement pourraient être respectivement formés par la différence et la somme de signaux proportionnels aux dérivées respectives en fonction du temps des courants circulant dans les conducteurs w1 et w2; ils pourraient aussi être respectivement constitués par la différence et la somme de signaux de courant de transition, tels que ceux utilisés dans le brevet américain US 4 366 474; ils pourraient encore être respectivement formés par la différence et la somme de signaux correspondant aux dérivées au cours du temps de tels signaux de courant de transition.

D'autres exemples de signaux de traitement seront donnés en référence aux différents modes de réalisation de l'invention, présentés de façon non limitative.

Néanmoins la figure 2, qui permet de comprendre le concept de base de l'invention, sera décrite en utilisant les signaux de courant Iw1 et Iw2 et, en tant que premier et second signaux de traitement, leur différence Iw1-Iw2 et leur somme Iw1 + Iw2.

Les figures 2A et 2B correspondent à un premier cas possible, et les figures 2C et 2D à un autre cas.

L'invention, telle qu'illustrée par ces figures, consiste essentiellement à élaborer, à partir des signaux de courant Iw1 et Iw2, les premier et second signaux de traitement Iw1-Iw2 et Iw1 + Iw2, à comparer à un seuil K, généralement compris entre 0.2 et 0.3, une grandeur de dissymétrie dont la valeur absolue est d'autant plus grande que la répartition du courant de la phase en défaut w entre les conducteurs w1 et w2 est moins symétrique, cette grandeur étant représentée sur les figures 2A et 2C comme étant proportionnelle au rapport de la projection sur le second signal de traitement $Iw1 + Iw2$ du premier signal de traitement $Iw1-Iw2$, au module de ce second signal de traitement, et à considérer comme sain le conducteur w1 ou w2 qui est associé au signal de courant $Iw1$ ou $Iw2$ ayant le module le plus faible, sous réserve que la grandeur de dissymétrie soit supérieure, en valeur absolue, au seuil K.

Plus précisément, si $Q(Iw1-Iw2)$ désigne la projection de $Iw1-Iw2$ sur $Iw1 + Iw2$ et si $M(X)$ désigne la mesure algébrique du vecteur X, l'invention consiste donc à considérer comme sain le conducteur associé au signal de courant ayant le plus petit module sous réserve que la grandeur de dissymétrie $R = Q(Iw1-Iw2)/M(Iw1 + Iw2)$ soit, en valeur absolue, au moins de l'ordre de 0.2.

Sur la figure 2A, le signal de courant de plus faible module est $Iw2$ et la rapport $R = Q(Iw1-Iw2)/M(Iw1 + Iw2)$ est de l'ordre de 0.5.; le conducteur W2, c'est-a-dire le conducteur assigné à la phase w dans le terne 2, est donc considéré comme sain.

Au contraire sur la figure 2C, le signal de courant de plus faible module est encore $Iw2$, mais le rapport $R = Q(Iw1-Iw2)/M(Iw1 + Iw2)$ n'est que de l'ordre de O.1; le conducteur w2 ne peut donc pas être considéré comme sain. ce qui signifie que le défaut de la phase w affecte les conducteurs w1 et w2.

Si, sur la figure 2A, le signal $Iw2$ prenait la place et le module du signal $Iw1$ originel, et réciproquement, rien ne serait changé à l'exception de la polarité du premier signal de traitement $Iw1-Iw2$, qui deviendrait négative.

Il est ainsi possible en utilisant uniquement les premier et second signaux de traitement, non seulement de détecter, lorsque c'est le cas, que le conducteur w2 est sain, mais aussi de détecter, lorsque c'est le cas, que le conducteur w1 est sain.

En effet, si la grandeur de dissymétrie $R = Q(Iwl-Iw2)/M(Iw1 + Iw2)$ est supérieure au seuil K, le conducteur w2 est sain, et si cette grandeur est inférieure à l'opposé - K du seuil K, le conducteur w1 est sain. Dans ces deux cas, la valeur absolue de la grandeur de dissymétrie est supérieure au seuil K. Si, par contre, la valeur absolue de cette grandeur est inférieure au seuil K (cas de la figure 2C), les deux conducteurs w1 et w2 sont présumés affectés par le défaut.

On peut remarquer sur les figures 2A et 2C que le second signal de traitement $Iw1 + Iw2$ est représenté par un vecteur horizontal, c'est-à-dire confondu avec l'axe des réels.

Cette configuration ne se produit que deux fois pour chaque période des signaux de courant $Iw1$ et $Iw2$, précisément à l'instant où le second signal de traitement $Iw1 + Iw2$ passe par un extremum, c'est-à-dire encore lorsque la valeur instantanée du signal $(Iw1 + Iw2, 90°)$, correspondant au second signal de traitement déphasé de 90°, est nulle.

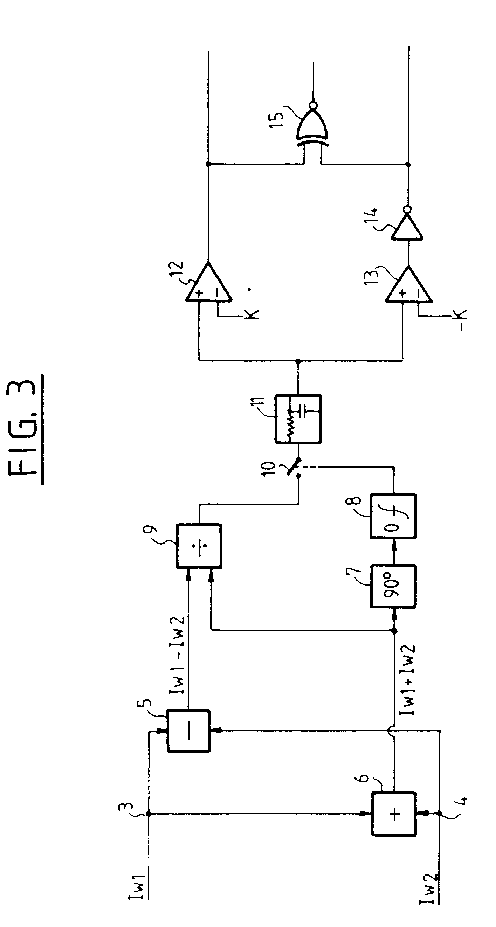

La figure 3 représenté un dispositif susceptible de mettre en oeuvre l'invention telle que décrite jusqu'à présent.

Les signaux $Iw1$ et $Iw2$ arrivent sur deux entrées 3, 4 de ce dispositif et parviennent à deux amplificateurs 5, 6 dont le premier élabore le premier signal de traitement $Iw1-Iw2$ et dont le second élabore le second signal de traitement $Iw1 + Iw2$. Un déphaseur 7 recevant le signal $Iw1 + Iw2$ élabore un signal, qui sera dit "signal pilote" et noté $(Iw1 + Iw2, 90°)$, ce signal étant obtenu à partir du second signal de traitement $Iw1 + Iw2$ par un déphasage de 90°, résultant par exemple d'une dérivation en fonction du temps de ce second signal de traitement.

Le signal pilote $(Iw1 + Iw2, 90°)$ parvient à un détecteur de passage à zéro 8 qui délivre une courte impulsion chaque fois que ce signal pilote passe à zéro.

Les premier et second signaux de traitement parviennent à un diviseur 9 qui délivre à un interrupteur 10 un signal représentatif de la valeur instantanée du rapport $r = (Iw1-Iw2)/(Iw1 + Iw2)$.

L'interrupteur 10, qui autorise ou interdit l'accès à un échantillonneur-bloqueur 11, est commandé par l'impulsion de sortie du détecteur de passage à zéro 8 de manière à se fermer pendant la durée de cette impulsion.

Ainsi l'échantillonneur-bloquer 11 mémorise la valeur du rapport r à l'instant où le signal pilot $(Iw1 + Iw2, 90°)$ passe par zéro, c'est-à-dire à l'instant où le second signal de traitement $Iw1 + Iw2$ passe par un extremum, c'est-à-dire encore à l'instant où ce dernier signal est représenté par un vecteur horizontal comme sur les figures 2A et 2C.

A cet instant, la projection $Q(Iw1-(Iw2)$ du premier signal de traitement $Iw1-Iw2$ sur le second $Iw1 + Iw2$ est simplement égale à ce premier signal de traitement, et la mesure algébrique $M(Iw1 + Iw2)$ du second signal de traitement $(Iw1 + Iw2)$ est égale à ce second signal de traitement.

Par conséquent, à cet instant, le rapport $r = (Iw1-Iw2)/(Iw1 + Iw2)$ représente la grandeur de dissymétrie $R = Q(Iw1-Iw2)/M(Iw1 + Iw2)$.

La valeur de cette grandeur R, mémorisée dans l'échantillonneur-bloqueur 11, est comparée au seuil K et à son opposé -K, dans deux comparateurs respectifs 12 et 13.

Le signal de sortie du comparateur 12 est à un niveau bas si la grandeur R est inférieure au seuil K et au niveau haut dans le cas contraire. Un niveau haut de ce signal, correspondant au cas de la figure 2A, indique que le défaut détecté sur la phase w affecte le conducteur w1 mais n'affecte pas le conducteur w2.

Le signal de sortie du comparateur 13 est au niveau bas si la grandeur R est inférieure à l'opposé -K du seuil K, et au niveau haut dans le cas contraire. Ce comparateur 13 est suivi par un inverseur 14 qui inverse les niveaux de ce comparateur. Un niveau haut du signal de sortie de l'inverseur 14 indique que le défaut détecté sur la phase w affecte le conducteur w2 mais n'affecte pas w1.

Les signaux de sortie du comparateur 12 et de l'inverseur 14 parviennent à une porte logique OU-EXCLUSIF-NON 15, qui ne délivre un signal au niveau haut que si les signaux de sortie du comparateur 12 et de l'inverseur sont au même niveau. Un niveau haut du signal de sortie de la porte 15 indique ainsi que les conducteurs w1 et w2 sont dans le même état vis-à-vis d'un défaut; si un défaut a été détecté sur la phase w d'une ligne triphasée à deux ternes, le niveau haut du signal de sortie de la porte 15 indique donc que les conducteurs w1 et w2 sont tous deux affectés par le défaut; cette situation, qui est celle représentée sur la figure 2C, correspond au cas où la grandeur de dissymétrie R est, en valeur absolue, inférieure au seuil K.

Le seuil K dépend des caractéristiques de la ligne et des sources S et P auxquelles elle est reliée, ainsi que la longueur du tronçon de ligne qu'on désire protéger, c'est-à-dire de la longueur du tronçon de ligne pour lequel on veut être capable, en cas de défaut affectant ce tronçon, de détecter l'existence éventuelle d'un conducteur sain.

Si l'on se place à l'extrémité A de la ligne, qui constitue le point de mesure où sont implantés les relais RA1 et RA2, on peut par exemple vouloir protéger (figure 1) un tronçon de longueur T à partir de ce point de mesure A. L'extrémité du tronçon T qui est opposée à A est dénommée "point de limite de protection" et l'on dit, dans le vocabulaire de l'homme de l'art, que le tronçon T s'étend en aval du point de mesure et en amont du point de limite de protection.

Si L désigne la longueur totale de la ligne, $Z_{sd}$ l'impédance directe de la source amont pour le point A, c'est-à-dire de la source S, $Z_{pd}$ l'impédance directe de la source aval pour le point A, c'est-à-dire de la source P et $z_d$ l'impédance linéique directe de la ligne, on sait que le pourcentage q de l'impédance directe située en aval du point de limite de protection, c'est-à-dire en dehors du tronçon T, par rapport à l'impédance totale de la ligne et des sources S et P est:

$$q = [2Z_{pd} + (L-T).z_d]/[2Z_{pd} + 2Z_{sd} + L.z_d].$$

Ceci étant rappelé, le seuil K est choisi comme étant égal ou au moins voisin du rapport d'une première grandeur g = l-t, au pourcentage q. Autrement dit: K = (l-t)/q

La première grandeur g = l-t est égale au complément à l de la fraction t de longueur de ligne que représente la longueur T du tronçon. En d'autres termes, g = l-(T/L) ou encore g = (L-T)/L, ce qui permet d'écrire aussi : K = (L-T)/L.q.

Par exemple, si L = 100 km, si T = 88 km, si $Z_{pd} = Z_{sd} = 20$ ohms et si $z_d = 0.3$ ohm/km, q est égal à 0.396, t = 0.88, g = 0.12 et K est donc choisi de l'ordre de 0.12/0.396, c'est-à-dire voisin de 0.3.

Pour K = 0.3, le procédé de l'invention permet, dans cet exemple numérique, de détecter l'existence éventuelle d'un conducteur sain dans le cas d'un défaut se produisant à une distance X du point A qui est inférieure à T = 88 km.

On peut calculer inversement que si L = 100 km, si $z_d = 0.3$ ohm/km si $Z_{sd} = 20$ ohms, si $Z_{pd} = 200$ ohms, et si K est choisi égal à 0.3, le procédé de l'invention permettra de détecter l'existence éventuelle d'un conducteur sain dans le cas d'un défaut affectant un tronçon de ligne de longueur T égale à 74 km.

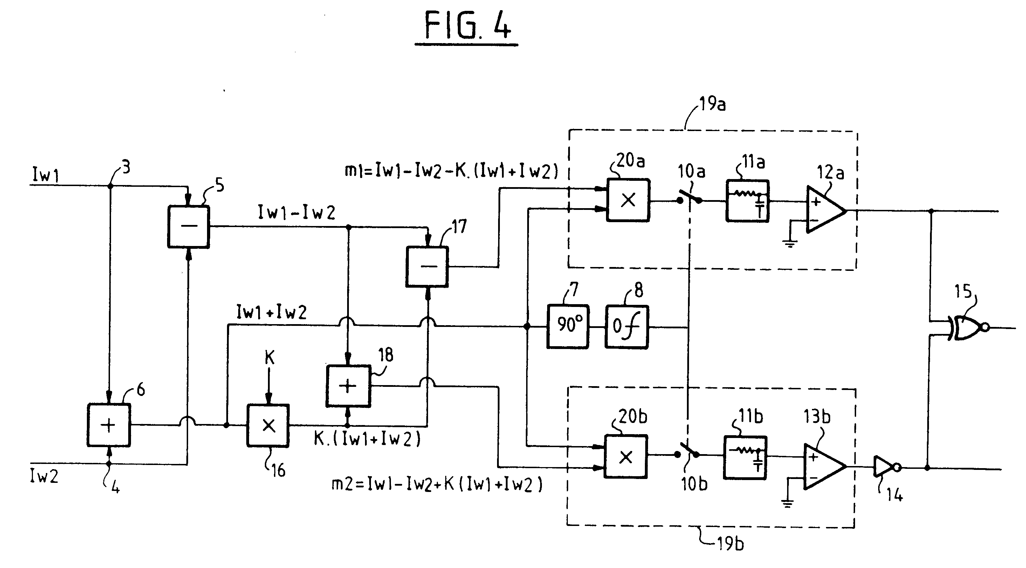

La figure 4 représente une première variante du mode de réalisation de la figure 3, illustrée également par les figures 2A à 2D.

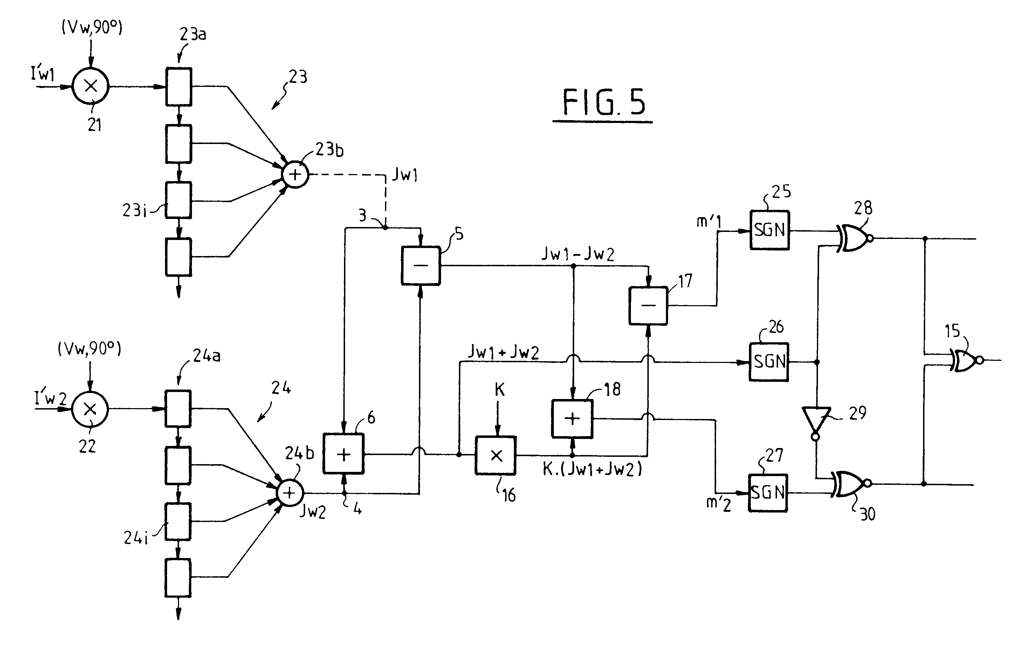

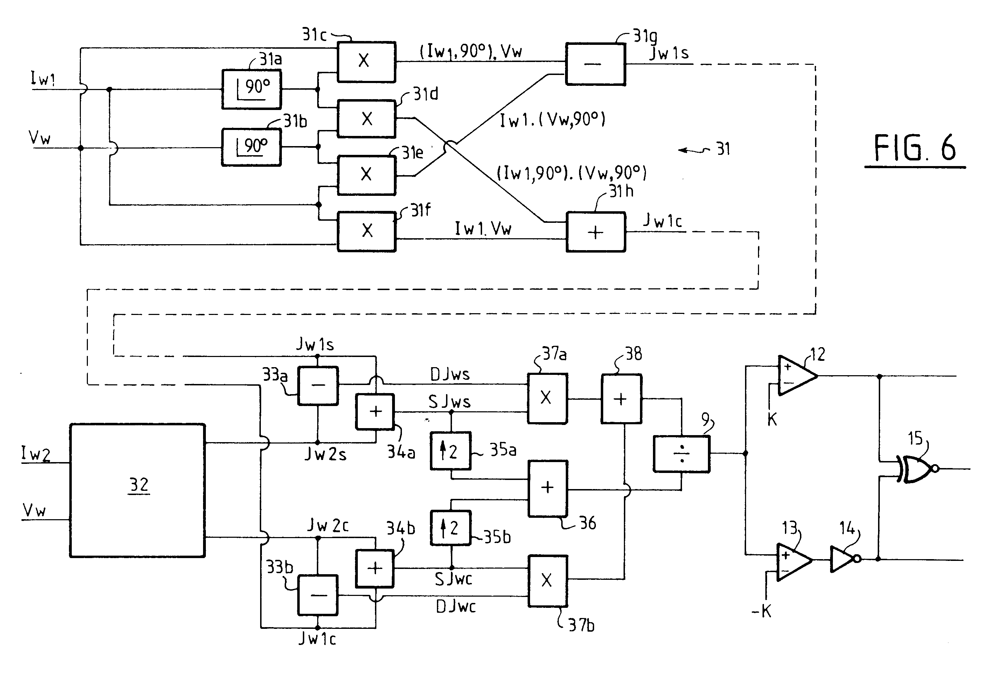

Bien que le dispositif de la figure 4 paraisse différent de celui de la figure 3, ces deux dispositifs, comme d'ailleurs celui des figures 5 et 6, mettent en oeuvre le même procédé et sont donc équivalents sur le plan fonctionnel, pour ce qui est de la discrimination d'un éventuel conducteur sain.

Dans le détail, la différence entre les dispositifs des figures 3 et 4 est la suivante : le dispositif de la figure 3 élabore réellement la grandeur de dissymétrie R = Q(lw1-lw2)/M(lw1 + lw2) et la compare au seuil K et à son opposé - K, alors que le dispositif de la figure 4 n'élabore qu'implicitement la grandeur de dissymétrie sous la forme de signaux mixtes (lw1-lw2)-K.(lw1 + lw2) et (lw1-lw2) + K.-(lw1 + lw2) dont la polarité est comparée à celle de lw1 + lw2.

On retrouve, dans le dispositif de la figure 4, les bornes 3 et 4, les amplificateurs 5 et 6 élaborant respectivement les premier et second signaux de traitement lw1-lw2 et lw + lw2, ainsi que le déphaseur 7 déphasant de 90° le second signal de traitement, et le détecteur de passage à zéro 8.

Ce dispositif comporte en outre un amplificateur 16 de gain K recevant le second signal de traitement lw1 + lw2 et produisant un signal intermédiaire K.(lw1 + lw2), et deux autres amplificateurs 17, 18 recevant ce signal intermédiaire et le premier signal de traitement pour produire respectivement des premier et second signaux mixtes, m1 = lw1-lw2-K.(lw1 + lw2) et m2 = lw1-lw2 + K-(lw1 + lw2).

Ces signaux mixtes m1 et m2 sont respectivement fournis à deux comparateurs de phase 19a et 19b qui reçoivent également de second signal de traitement Iw1 + Iw2.

Ces comparateurs de phase 19a et 19b sont commandés par le signal pilote (Iw1 + Iw2, 90°) délivré par le détecteur 8 de passage à zéro, et ont chacun pour fonction de délivrer, au moment où le signal pilote passe par zéro, un signal au niveau haut si le déphasage entre le signal mixte et le second signal de traitement appliqués à leur entrée est, en valeur absolue, inférieure à 90°, le signal de sortie de ces comparateurs étant au niveau bas dans le cas contraire.

Par exemple, le comparateur de phase 19a comprend un multiplieur 20a recevant le premier signal mixte m1 et le second signal de traitement, un interrupteur 10a disposé en sortie du multiplieur et commandé par le signal pilote comme l'était l'interrupteur 10 du dispositif de la figure 3, un échantillonneur-bloqueur 11a homologue de l'échantillonneur-bloqueur 11, et un comparateur 12a comparant à zéro le signal de sortie de l'échantillonneur-bloqueur 11a. Le comparateur de phase 19b comporte des éléments homologues, à savoir un multiplieur 20b, un interrupteur 10b, un échantillonneur-bloqueur 11b et un comparateur 13b. La sortie du second comparateur de phase 19b est reliée à un inverseur 14, homologue de l'inverseur 14 de la figure 3.

Dans le cas où le conducteur w1 est seul affecté par le défaut (cas de la figure 2B), le déphasage absolu entre le second signal de traitement Iw1 + Iw2 et le premier signal mixte m1 = Iw1-Iw2-K (Iw1 + Iw2) est inférieur à 90°, ce qui signifie que ces signaux ont même polarité (positive dans le cas de la figure 2 puisque les vecteurs associés pointent tous deux vers l'est), ce qui signifie encore que leur produit est positif; donc les signaux de sortie du multiplieur 20a et de l'échantillonneur-bloqueur 11a sont positifs, de sorte que le signal de sortie du comparateur 12a est au niveau haut.

Dans le cas où le conducteur w2 est seul affecté par le défaut, le second signal mixte m2 = -(Iw1-Iw2) + K.(Iwl + Iw2) et le second signal de traitement Iw1 + Iw2 sont de polarités opposées, de sorte que le signal de sortie du comparateur 13b est au niveau bas et que le signal de l'inverseur 14 est au niveau haut.

Enfin, la porte OU-EXCLUSIF-NON 15, homologue de la porte 15 du dispositif de la figure 3, délivre un signal de sortie au niveau bas lorsque les conducteurs w1 et w2 sont dans des états différents (figures 2A et 2B) c'est-à-dire lorsque l'un est sain et l'autre affecté par le défaut, et au niveau haut lorsque ces conducteurs sont dans un même état (figures 2C et 2D).

La figure 5 représente un troisième mode de réalisation d'un dispositif pour mettre en oeuvre le procédé de l'invention. La différence entre ce dispositif et ceux des figures 3 et 4 est essentiellement une différence de structure et réside dans le fait que le dispositif de la figure 5 utilise des signaux scalaires de traitement, comme cela sera expliqué en détail ci-après; sur le plan fonctionnel, vis-à-vis du concept général de l'invention, le dispositif de la figure 5 est équivalent aux dispositifs des figures 3 et 4 à ceci près que ce dispositif n'est utilisable que dans le cas où la résistance du défaut se manifestant sur la phase w est relativement faible.

La figure 6 montrera un dispositif analogue à celui de la figure 5, mais utilisable quelque soit la résistance du défaut.

En plus des premier et second signaux de traitement Jw1-Jw2 et Jw1 + Jw2, qui sont à rapprocher des signaux Iw1-Iw2 et Iw1 + Iw2 mais qui seront décrits plus en détail ci-après, le dispositif de la figure 5 utilise plusieurs autres signaux de traitement.

Sur ses entrées, ce dispositif reçoit des signaux de traitement particuliers I'w1 et I'w2 qui seront ci-après désignés comme premier et second signaux de courant de transition.

Le premier courant de transition I'w1 est obte-nu comme étant égal ou au moins proportionnel à la différence entre la valeur adoptée à cet instant par le premier signal de courant Iw1 et la valeur iw1 qu'aurait eu ce signal de courant Iwl au même instant en l'absence de défaut. Le second signal de courant de transition I'w2 est obtenu de façon analogue. L'utilisation de tels signaux de courant de transition est connue de l'homme de l'art, et par exemple décrite dans le brevet américain US 4 366 474.

Le dispositif de la figure 5 utilise en outre un signal de référence (Vw, 90°) obtenu en déphasant de 90° un signal de référence initial Vw. Dans le cas particulier du dispositif de la figure 5, ce signal de référence initial Vw est constitué par le signal de tension de la phase w, tel qu'il aurait existé en l'absence de défaut sur la phase w. Ce signal Vw est donc obtenu, comme le signal iw1 pour le courant, par extrapolation après l'apparition du défaut, du signal de tension de la phase w tel qu'il était délivré par le relais RA$_1$ (ou, en l'occurence, par le relais RA$_2$ puisque le signal de tension est commun aux ternes 1 et 2) avant le défaut.

Le dispositif de la figure 5 comprend deux multiplieurs 21 et 22 conçus pour former respecti-vement les produits I'w1. (Vw, 90°) et I'w2.(Vw, 90°).

Le dispositif comprend par ailleurs deux intégrateurs 23 et 24 adoptant la forme d'intégrateurs analogiques ou, comme représenté sur la figure 5, la forme d'intégrateurs numériques. Dans ce dernier cas chaque intégrateur 23, 24, comporte d'une part un registre à décalage tel que 23a ou 24a, dont les différentes cellules telles que 23i ou 24i mémorisent des valeurs instantanées successives du produit I'w1.(Vw, 90°) ou I'w2.(Vw, 90°), et d'autre part un sommateur tel que 23b ou 24b effectuant la somme des valeurs contenues dans l'ensemble des cellules du registre à décalage associé. La longueur des registres à décalage 23a, 24a, est telle que ces registres contiennent l'ensemble des valeurs instantanées successives de produit qui ont été élaborées sur un intervalle de temps égal à un multiple d'une demi-période du signal de référence initial Vw.

Les sommateurs 23b et 24b délivrent ainsi des signaux respectifs Jw1 et Jw2 qui sont représentés respectivement par des intégrales, ou des sommes discrètes, sur un intervalle de temps égal à ou multiple d'une demi-période du signal de référence (Vw, 90°), du produit scalaire de ce signal de référence avec les premier et second signaux de courant de transition I'w1 et I'w2.

Les signaux Jw1 et Jw2 parviennent, à travers deux bornes 3, 4 du dispositif, à deux amplificateurs 5, 6 dont le premier élabore le signal différence Jw1-Jw2 et dont le second élabore le signal somme Jw1 + Jw2.

Ainsi qu il a été dit précédemment, les signaux Jw1-Jw2 et Jw1 + Jw2, qui seront dénommés "premier et second signaux scalaires de traitement", sont à rapprocher des premier et second signaux de traitement Iw1-Iw2 et Iw1 + Iw2 présentés en référence aux figures 3 et 4.

Cependant, à la différence des signaux Iw1-Iw2 et Iw1 + Iw2, qui évoluent au cours du temps en fonction des valeurs instantanées de module et d'angle de phase des signaux Iw1 et Iw2, les signaux Jw1, Jw2, Jw1-Jw2, et Jw1 + jw2 n'évoluent au cours du temps qu'en fonction du module des signaux I'w1 et/ou I'w2.

Cette différence tient au fait que les signaux Jw1 et Jw2 sont obtenus par produit scalaire des signaux I'w1 et I'w2 par le signal (Vw, 90°) dont la fréquence est la même que celle de I'w1 et I'w2.

Si le module M(I'w1) du signal I'w1 est, comme le module M(Vw) du signal Vw, constant, le signal Jw1 sera par exemple égal, à tout instant, à M-(I'w1).M(Vw).Sin(f) où f est la différence de phase constante entre I'w, et Vw.

Les circuits, tels que 21 et 23 ou 22 et 24, dont la finalité est de produire, grâce à un signal de référence tel que (Vw, 90°), des signaux tels que Jw1, Jw2, Jw1-Jw2, Jw1 + Jw2, essentiellement indépendants de la fréquence des signaux de courant Iw1, Iw2, peuvent revêtir d'autres formes, comme cela sera présenté en référence à la figure 6.

De tels signaux Jw1, Jw2, Jw1-Jw2, Jw1 + Jw2, indépendants de la fréquence des signaux Iw1 et Iw2 peuvent être avantageusement utilisés dans le cas où les relais RA1 est RA2 sont physiquement éloignés l'un de l'autre, c'est-à-dire dans les cas où le signal de courant d'un relais, par exemple RA1, doit être transmis à l'autre relais, par exemple RA2. Le fait de transmettre un signal tel que Jw1, au lieu d'un signal de courant de type vectoriel, tel que Iw1, permet d'éviter d'avoir à corriger les erreurs introduites dans la valeur du signal transmis en raison du retard que la transmission de ce signal fait apparaître.

En plus des moyens pour élaborer les premier et second signaux scalaires de traitement Jw1-Jw2 et Jw1 + Jw2, le dispositif comprend par exemple un amplificateur 16 de gain K recevant le signal Jw1 + Jw2 et produisant un signal intermédiaire K.-(Jw1 + Jw2). Deux autres amplificateurs 17, 18, recevant ce signal intermédiaire et le premier signal scalaire de traitement Jw1-Jw2 produisent respectivement des premier et second signaux mixtes :m'1 = Jw1-Jw2-K.(Jw1 + Jw2)    et    m'2 = Jw1-Jw2 + K.(Jw1 + Jw2).

Le dispositif comprend trois détecteurs de polarité (ou signe) 25, 26, 27, recevant respectivement le premier signal mixte m'1, le second signal scalaire de traitement Jw1 + Jw2, et le second signal mixte m'2. Chacun de ces détecteurs de polarité délivre sur sa sortie un signal au niveau haut si le signal qu'il reçoit sur son entrée est de polarité positive, et un signal de sortie au niveau bas si le signal d'entrée est de polarité négative.

Une porte OU-EXCLUSIF-NON 28 reçoit sur ses entrées les signaux de sortie des détecteurs de polarité 25 et 26 et délivre donc un signal de sortie au niveau haut si les polarités du premier signal mixte m1 et du second signal de traitement Jw1 + Jw2 coïncident, ce qui indique, comme dans le cas du dispositif de la figure 4, que le conducteur w2 est sain alors que le conducteur w1 est affecté par le défaut.

Un inverseur 29 inverse les niveaux du signal de sortie du détecteur de polarité 26.

Une porte OU-EXCLUSIF-NON 30 reçoit sur ses entrées le signal issu de l'inverseur 29 et le signal de sortie du détecteur de polarité 27; cette porte 30 délivre donc un signal de sortie au niveau haut si les polarités du second signal mixte m2 et du second signal de traitement Jw1 + Jw2 sont différentes, ce qui indique, comme dans le cas du dispositif de la figure 4, que le conducteur w1 est sain alors que le conducteur w2 est affecté par le défaut.

Une porte OU EXCLUSIF-NON 15, reliée aux portes 28 et 30, produit un signal de sortie au niveau bas si les conducteurs w1 et w2 sont dans des états différents, c'est-à-dire si l'un est affecté par le défaut et l'autre sain, et un signal de sortie au niveau haut si les conducteurs w1 et w2 sont dans le même état.

L'équivalence fonctionnelle du dispositif de la figure 5 et les dispositifs des figures 3 et 4, vis-à-vis du résultat que contitue la discrimination de conducteur en défaut tient au fait que, dans l'application prévue du dispositif de la figure 5, c'est-à-dire dans le cas où la résistance du défaut affectant la phase w est faible, la somme I'w1 + I'w2 des signaux de courant de transition I'w1 et I'w2 se trouve en phase avec le signal de référence (Vw, 90°).

Il en résulte que le premier signal scalaire de traitement Jw1-Jw2 a, pendant un certain intervalle de temps après le défaut, la valeur que prend la différence I'w1-I'w2 des signaux de courant de transition I'w1 et I'w2 à l'instant précis où la somme I'w1 + I'w2 de ces signaux passe par un extremum.

Le dispositif de la figure 6, utilisable quelque soit la résistance du défaut, reçoit par exemple sur ses entrées les signaux de courant Iw1 et Iw2 et le signal de référence Vw.

A la place des signaux Iw1 et Iw2, ce dispositif pourrait toutefois utiliser des signaux de traitement obtenus à partir de ces signaux de courant, par exemple des signaux de courant de transition I'w1 et I'w2, ou des signaux obtenus par dérivation en fonction du temps soit des signaux Iw1 et Iw2 soit des signaux I'w1 et I'w2, etc.

Par ailleurs, à la place du signal de référence Vw, ce dispositif de la figure 6 pourrait aussi utiliser le signal de référence (Vw, 90°) précédemment évoqué, ou tout autre signal sinusoïdal d'amplitude constante, de même période que les signaux de courant Iw1, et Iw2 et disponible à l'extrémité A de la ligne.

Ce dispositif comprend deux circuits 31, 32 fournissant respectivement des signaux Jw1S et Jw1C d'une part et Jw2S et Jw2C d'autre part.

Seul le circuit 31 est représenté complètement, le circuit 32, identique au circuit 31, étant représenté simplement sous la forme d'un bloc fonctionnel.

Le circuit 31 comprend un déphaseur 31a recevant, et déphasant de 90°, le signal Iw1 et un déphaseur 31b recevant, et déphasant de 90° le signal Vw. Les signaux Iw1, Iw2, et les signaux de sortie (Iw1, 90°) et (Vw,90°) des déphaseurs 31a et 31b sont envoyés deux par deux sur des multiplieurs 31c à 31f qui délivrent des signaux produits respectifs (Iw1,90°).Vw, Iw1.(Vw,90°),(Iw1,90°).-(Vw, 90°), et Iw1.Vw.

La différence des deux premiers de ces signaux est formé dans le soustracteur 31g qui délivre le signal Jw1S = (Iw1,90°).Vw-Iw1.(Vw,90°) et la somme des deux derniers de ces signaux est formée dans le sommateur 31h qui délivre le signal Jw1C = (Iw1,90°).(Vw,90°) + Iw1.Vw.

Le circuit 32 délivre des signaux homologues Jw2S = (Iw2,90°).Vw-Iw2.(Vw,90°) et Jw2SC = -(Iw2,90°).(Vw,90°) + Iw2.Vw.

Si l'on appelle p1 l'angle de phase entre les signaux Iw1 et Vw, p2 l'angle de phase entre les signaux Iw2 et Vw, M(Iw1) le module du signal Iw1, M(Iw2) celui du signal Iw2 et M(Vw) celui du signal Vw, on peut montrer que :

$$Jw1S = M(Iw1).M(Vw).\sin p1$$
$$Jw1C = M(Iw1).M(Vw).\cos p1$$
$$Jw2S = M(Iw2).M(Vw).\sin p2$$
$$Jw2C = M(Iw2).M(Vw).\cos p2$$

Ces quatre signaux Jw1S, Jw1C, Jw2S, Jw2C sont donc des signaux scalaires de traitement, puisqu'ils sont indépendants de la fréquence des signaux Iw1 et Iw2.

Ainsi, comme les signaux Jw1 ou Jw2 du dispositif de la figure 5, les signaux Jw1C et Jw1S ou Jw2C et Jw2S peuvent être transmis aisément du relais RA1 à l'autre RA2 ou inversement, sans soulever des problèmes de correction d'erreurs introduites par des retards de transmission.

Un soustracteur 33a et un sommateur 34a forment des signaux respectifs DJwS = Jw1S-Jw2S et SJwS = Jw1S + Jw2S.

De façon homologue, le soustracteur 33b et le sommateur 34b forment des signaux respectifs DJwC = Jw1C-Jw2C et SJwC = Jw1C + Jw2C.

Les signaux SJwS et SJwC, élevés à la puissance 2 dans des générateurs de fonction respectifs 35a, 35b, sont ensuite additionnés dans un sommateur 36.

Les signaux DJwS et SJwS sont multipliés entre eux dans le multiplieur 37a tandis que les signaux DJwC et SJwC sont multipliés entre eux dans le multiplieur 37b. Les signaux de sortie DJwS.SJwS et DJwC.SJwC des multiplieurs 37a et 37b sont additionnés dans le sommateur 38.

Le signal de sortie du sommateur 38, égal à DJwS.SJwS + DJwC.SJwC, est fourni à un diviseur 9 qui le divise par le signal de sortie du sommateur 36, égal à $(SJwS)^2 + (SJwC)^2$.

On peut montrer, par un développement mathématique accessible à l'homme de l'art ayant bénéficié de l'enseignement de la présente description, que le diviseur 9 fournit, pendant un certain intervalle de temps après l'apparition du défaut, un signal de sortie égal au signal de sortie que fournit le diviseur 9 du dispositif de la figure 3 à l'instant précis où le second signal de traitement Iw1 + Iw2 passe par un extremum.

Le signal de sortie du diviseur 9 du dispositif de la figure 6 est donc traité, grâce aux comparateurs 12 et 13 et aux portes logiques 14 et 15 déjà décrits, comme l'est le signal de sortie du diviseur 9 du dispositif de la figure 3.

## Revendications

1. Procédé pour déterminer à quel groupe polyphasé de conducteurs appartient un conducteur affecté par un défaut se manifestant sur une phase d'une ligne électrique à au moins deux groupes polyphasés (1, 2) dont les phases correspondantes (a, b, c) sont reliées en parallèle à une extrémité de la ligne au moins, comprenant les opérations consistant à :

- recueillir, en un point de mesure de la ligne, des premier et second signaux de courant (IW1, IW2) proportionnels aux valeurs instantanées des courants circulant dans des premier et second conducteurs (W1, W2) qui, respectivement dans les premier et second groupes, sont les conducteurs assignés à la phase vue en défaut,
- élaborer des signaux de traitement représentés par des combinaisons des premier et second signaux de courant,
- effectuer une opération évoluée de comparaison consistant à ou équivalent à comparer à un seuil (K) de valeur déterminée une grandeur de dissymétrie (R) exprimable comme une fonction desdits signaux de traitement et représentative de la dissymétrie de la répartition entre les premier et second conducteurs, du courant de la phase en défaut, et
- élaborer au moins un premier signal de sortie identifiant comme sain le conducteur associé au signal de courant ayant le plus faible module, sous réserve que ladite grandeur de dissymétrie dépasse, en valeur absolue, le seuil de valeur déterminée,

caractérisé en ce que ladite grandeur de dissymétrie (R) est proportionnelle au produit, par le cosinus de l'angle de phase entre la différence (Iw1-Iw2) et la somme (Iw1 + Iw2) des premier et second signaux de courant, du rapport du module de la différence de ces signaux de courant au module de leur somme.

2. Procédé suivant la revendication 1 caractérisé en ce que l'élaboration des signaux de traitement comprend l'élaboration d'un premier signal de traitement fonction de la différence (Iw1-Iw2) des premier et second signaux de courant, et élaboration d'un second signal de traitement fonction de la somme (Iw1 + Iw2) des premier et second signaux de courant.

3. Procédé suivant l'une des revendications 1 et 2, caractérisé en ce qu'il comprend l'élaboration de premier et second signaux de sortie identifiant, respectivement au premier et second conducteur, ou inversement, le conducteur sain et le conducteur affecté par le défaut, selon que ladite grandeur de dissymétrie (R) est négative, ou positive, sous réserve que cette grandeur soit, en valeur absolue, supérieure audit seuil déterminé (K).

4. Procédé suivant la revendication 3, caractérisé en ce qu'il comprend l'élaboration d'un troisième signal de sortie identifiant les deux conducteurs comme étant tous deux affectés par un défaut si ladite grandeur de dissymétrie (R) est, en valeur absolue, inférieure audit seuil déterminé (K).

5. Procédé suivant l'une quelconque des revendications précédentes, combinée à la revendication 2, caractérisé en ce que ladite opération évoluée de comparaison comprend d'une part l'élaboration d'au moins un premier signal mixte (m1) proportionnel à la différence du premier signal de traitement et du produit de ladite valeur de seuil avec le second signal de traitement, et d'autre part au moins une première opération élémentaire de comparaison consistant essentiellement à comparer les polarités respectives de ce premier signal mixte (m1) et du second signal de traitement.

6. Procédé suivant la revendication 5, caractérisé en ce que ladite opération évoluée de comparaison comprend en outre d'une part l'élaboration d'un second signal mixte (m2) proportionnel à la somme du premier signal de traitement et du produit de ladite valeur de seuil avec le second signal de traitement, et, d'autre part, une seconde opération élémentaire de comparaison consistant essentiellement à comparer les polarités respectives du second signal mixte et du second signal de traitement.

7. Procédé suivant l'une quelconque des revendications 1 à 6, appliqué à la protection d'un tronçon de ligne dont la longueur (T) est représentée par une fraction de la longueur totale (L) de la ligne, et qui est situé en aval du point de mesure et en amont d'un point de limite de protection, caractérisé en ce que ledit seuil est, en valeur absolue, sensiblement égal au rapport d'une première grandeur représentée par le complément à "1" de ladite fraction de longueur totale de ligne, à une seconde grandeur représentée par le pourcentage, par rapport à l'impédance totale de la ligne et des sources (S,P) auxquelles elle est reliée, de l'impédance située en aval du point de limite de protection.

8. Procédé suivant l'une quelconque des revendications 1 à 7, caractérisé en ce qu'il comprend l'élaboration, en tant que signaux de traitement, de premier et second signaux de courant de transition (I'w1, I'w2) dont chacun est, la chaque instant, proportionne[ à la différence entre la valeur à cet instant du signal de courant correspondant et la valeur qu'aurait eu ce signal de courant au même instant en l'absence de défaut.

9. Procédé suivant l'une quelconque des revendications 1 à 8, combinée à la revendication 2 , caractérisé en ce que lesdits signaux de traitement varient au cours du temps en fonction des valeurs instantanées de module et d'angle de phase des premier et second signaux de courant, et en ce que ladite opération évoluée de comparaison est effectuée à un instant où le second signal de traitement passe par un extremum.

10. Procédé suivant l'une quelconque des revendications 1 à 7, caractérisé en ce qu'il comprend l'élaboration, en tant que premier et second signaux de traitement, de Signaux scalaires de traitement (Iw1-Iw2, Iw1 + Iw2) qui ne varient au cours du temps qu'en fonction du module des premier et second signaux de courant.

11. Procédé pour déterminer à quels ternes respectifs appartiennent des conducteurs affectés par des défauts se manifestant sur au moins deux phases d'une ligne électrique à deux ternes dont les phases correspondantes sont reliées en parallèle, consistant à mettre en oeuvre, pour chacune des phases en défaut, un procédé suivant l'une quelconque des revendications précédentes.

12. Dispositif pour déterminer à quel groupe polyphasé de conducteurs appartient un conducteur affecté par un défaut se manifestant sur une phase d'une ligne électrique à au moins deux groupes polyphasés dont les phases correspondantes sont reliées en parallèle à une extrémité de la ligne au moins, comprenant :
   - des moyens de combinaison (3, 5, 6), pour élaborer des signaux de traitement représentés par des combinaisons de premier et second signaux de courant, ces derniers étant proportionnels aux valeurs instantanées des courants circulant dans des premier et second conducteurs qui, respectivement dans les premier et second groupes, sont les conducteurs assignés à la phase vue en défaut,
   - des moyens (7, 8, 9, 10, 11) pour effectuer une opération évoluée de comparaison consistant à ou équivalant à comparer à un seuil de valeur déterminée une grandeur de dissymétrie exprimable comme une fonction desdits signaux de traitement et représentative de la dissymétrie de la répartition, entre les premier et second conducteurs, du courant de la phase en défaut, et
   - des moyens (12, 13, 14, 15) pour élaborer au moins un premier signal de sortie identifiant comme sain le conducteur associé au signal de courant ayant le plus faible module, sous réserve que ladite grandeur de dissymétrie dépasse, en valeur absolue, ledit seuil de valeur déterminée, caractérisé en ce que ladite grandeur de dissymétrie (R) est proportionnelle au produit, par le cosinus de l'angle de phase entre la différence (Iw1-Iw2) et la somme (Iw1 + Iw2) des premier et second signaux de courant, du rapport de module de la différence de ces signaux de courant au module de leur somme.

13. Dispositif suivant la revendication 12, caractérisé en ce que lesdits moyens pour élaborer des signaux de traitement comprennent des moyens (5) pour élaborer le premier signal de traitement fonction de la différence (Iw1-Iw2) des premier et second signaux de courant, et des moyens (6) pour élaborer un second signal de traitement fonction de la somme (Iw1 + Iw2) des premier et second signaux de courant.

**Claims**

1. A method for determining to what polyphase group of conductors belongs a conductor affected by a fault which is present in a phase of an electric line having at least two polyphase groups (1, 2) whose corresponding phases (a, b, c) are connected in parallel at least at one end of the line, comprising the operation consisting in:
   - receiving, at a measurement point of the line, first and second current signals (Iw1, Iw2) proportional to the instantaneous values of current passing through first and second conductors (W1, W2) which, respectively in the first and second groups, are the conductors allocated to the phase appearing to be faulty,
   - generating process signals represented by combinations of the first and second current signals,
   - performing an evolved comparison operation consisting in or equivalent to comparing, with as predetermined threshold value (K), a value of asymmetry (R), suitable for being expressed as a function of said process signals and representative of the asymmetry of repartition of the current of the faulty phase between the first and second conductors, and

- generating at least a first output signal identifying the one of the conductors to be sound which is associated with the current signal having the lower modulus, provided said asymmetry value exceeds, in absolute value, said predetermined threshold value,

characterized in that said value of asymmetry (R) is proportional to the product of the cosine of the phase angle between the difference (Iw1 - Iw2) and the sum (Iw1 + Iw2) of the first and second current signals and the ratio of the modulus of the difference of said current signals to the modulus of their sum.

2. A method according to claim 1, characterized in that the generation of the process signals comprises the generation of a first process signal depending on the difference (Iw1 - Iw2) between the first and second current signals, and the generation of a second process signal depending on the sum (Iw1 + Iw2) of the first and second current signals.

3. A method according to claim 1 or 2, characterized in that it comprises the generation of first and second output signals identifying respectively the first conductor as a sound one and the second conductor as a faulty one, or inversely, according to whether said asymmetry value (R) is negative or positive, provided that said value is, as absolute value, greater than said predetermined threshold (K).

4. A method according to claim 3, characterized in that it comprises the generarion of a third output signal identifying the two conductors as being both subject to the fault, if said value of asymmetry (R) is, as absolute value, smaller than said predetermined threshold (K).

5. A method according to any one of the preceding claims, combined with claim 2, characterized in that said evolved comparison operation includes on the one hand the generation of at least one first mixed signal (m1) proportional to the difference between the first process signal and the product of said threshold value with the second process signal, and on the other hand at least one first elementary comparison operation consisting essentially in comparing the respective polarities of this first mixed signal (m1) with the second process signal.

6. A method according to claim 5, characterized in that said evolved comparison operation further includes on the one hand the generation of a second mixed signal (m2) proportional to the sum of the first process signal and the product of said threshold value and the second process signal, and on the other hand a second elementary comparison operation essentially consisting in comparing the respective polarities of the second mixed signal and the second process signal.

7. A method according to any one of claims 1 to 6, applied to the protection of a portion of the line whose length (T) is represented by a fraction of the total line length (L), and which is located downstream of a measurement point and upstream of a protection limitation point, characterized in that said threshold is, in absolute value, substantially equal to the ratio between a first value represented by the ones-complement of said fraction of the total length of the line, and a second value represented by the percentage of the impedance located downstream of the protection limitation point with respect to the total impedance of the line and of the power sources (S, P) to which the line is connected.

8. A method according to any one of claims 1 to 7, characterized in that it includes the generation of first and second current transition signals (I'w1, I'w2) as process signals, each of which is, at any instant, proportional to the difference between the value of the respective current signal at that instant and the value which said current signal would have had at that same instant in the absence of the fault.

9. A method according to any one of claims 1 to 8, combined with claim 2, characterized in that the process signals vary in time as a function of the instantaneous values of the module and phase angle of the first and second current signals, and in that said evolved comparison operation is performed at a time instant where the second process signal passes through an extreme value.

10. A method according to any one of claims 1 to 7, characterized in that it comprises the generation of scalar process signals (Iw1-Iw2, Iw1 + Iw2) as first and second process signals, which vary in time as a function of the modulus of the first and second current signals.

11. A method for determining to what polyphase group of conductors belongs a conductor affected by a fault which is present in a phase of an electric line consisting of two ternary groups, whose corresponding phases are connected in parallel, consisting in implementing for each of the faulty phases a method according to any one of the preceding claims.

12. An apparatus for determining to what polyphase group of conductors belongs a conductor affected by a fault which is present in a phase of an electric line consisting of at least two polyphase groups, whose corresponding phases are connected in parallel at least at one end of the line, comprising:
 - logic means (3, 5, 6) for generating process signals represented by combinations of first and second current signals, the latter being proportional to the instantaneous values of the currents passing through first and second conductors which, respectively in the first and second groups, are the conductors allocated to the faulty phase,
 - means (7, 8, 9, 10, 11) for performing an evolved comparison operation consisting of or being equivalent to comparing, with a predetermined threshold value, a value of asymmetry suited for being expressed as a function of said process signals and representative of the asymmetry of repartition of the current of the faulty phase between the first and second conductors, and
 - means (12, 13, 14, 15) for generating at least a first output signal identifying the conductor associated with a current signal having the lower modulus as being sound, provided that said value of asymmetry exceeds, as absolute value, said predetermined threshold value, characterized in that said value of asymmetry (R) is proportional to the product of the cosine of the phase angle between the difference (lw1 - lw2) and the sum (lw1 + lw2) of the first and second current signals with the ratio of the modulus of the difference of said current signals to the modulus of their sum.

13. An apparatus according to claim 12, characterized in that said means for generating process signals include means (5) for generating a first process signal as a function of the difference (lw1 - lw2) between the first and second current signals, and means (6) for generating a second process signal as a function of the sum (lw1 + lw2) of the first and second current signals.

**Patentansprüche**

1. Verfahren zur Ermittlung, welcher Mehrphasenleitergruppe ein von einem Fehler betroffener Leiter angehört, wobei sich der Fehler auf einer Phase einer elektrischen Leitung bestehend aus mindestens zwei Mehrphasengruppen (1, 2) bemerkbar macht, deren entsprechende Phasen (a, b, c) mindestens an ein Ende der Leitung parallelgeschaltet sind, wobei das Verfahren die folgenden Schritte aufweist:
 - an einem Meßpunkt werden der Leitung erste und zweite Stromsignale (IW1, IW2) empfangen, die den Momentanwerten der im ersten und zweiten Leiter (W1, W2) fließenden Ströme proportional sind, wobei diese Leiter in der ersten bzw. zweiten Gruppe die der fehlerbehafteten Phase zugewiesenen Leiter sind;
 - man erzeugt Verarbeitungssignale, die durch Kombinationen des ersten und des zweiten Stromsignals gebildet werden;
 - man führt eine fortgeschrittene Vergleichsoperation durch, bestehend aus bzw. äquivalent dem Vergleich einer Asymmetriegröße (R) mit einem Schwellenwert (K) bestimmter Größe, wobei die Asymmetriegröße als Funktion der Verarbeitungssignale ausdrückbar und repräsentativ für die Asymmetrie der Verteilung des Stroms der fehlerhaften Phrase zwischen dem ersten und dem zweiten Leiter ist;
 - man erzeugt mindestens ein erstes Ausgangssignal, das den dem Stromsignal mit dem kleineren Modul zugeordneten Leiter als störungsfrei identifiziert, vorausgesetzt, daß die Asymmetriegröße absolut gesehen den festgesetzten Schwellenwert übersteigt,
dadurch gekennzeichnet, daß die Asymmetriegröße (R) dem Produkt des Cosinus des Phasenwinkels zwischen der Differenz (lw1 - lw2) und der Summe (lw1 + lw2) des ersten und zweiten Stromsignals mit dem Verhältnis des Moduls der Differenz dieser Stromsignale zum Modul ihrer Summe proportional ist.

2. Verfahren nach Anspruch 1, dadurch gekennzeichnet, daß die Erzeugung der Verarbeitungssignale die Erzeugung eines ersten Verarbeitungssignals, das Funktion der Differenz (lw1 - lw2) der ersten und zweiten Stromsignale ist, und die Erzeugung eines zweiten Verarbeitungssignals umfaßt, das Funktion der Summe (Iw1 + Iw2) der ersten und zweiten Stromsignale ist.

3. Verfahren nach Anspruch 1 oder 2, dadurch gekennzeichnet, daß es die Erzeugung eines ersten und eines zweiten Ausgangssignals umfaßt, die beim ersten bzw. zweiten Leiter oder umgekehrt den störungsfreien und den vom Fehler betroffenen Leiter identifizieren, je nachdem, ob die Asymmetriegröße (R) negativ oder positiv ist, vorausgesetzt, daß die Größe absolut gesehen größer als der festgesetzte Schwellenwert (K) ist.

4. Verfahren nach Anspruch 3, dadurch gekennzeichnet, daß es die Erzeugung eines dritten Ausgangssignals umfaßt, das die beiden Leiter als beide von einem Fehler betroffen identifiziert, falls die Asymmetriegröße (R) als Absolutwert kleiner als der festgesetzte Schwellenwert (K) ist.

5. Verfahren nach einem beliebigen der vorhergehenden Ansprüche in Kombination mit Anspruch 2, dadurch gekennzeichnet, daß die fortgeschrittene Vergleichsoperation zum einen die Erzeugung mindestens eines ersten gemischten Signals (m1) proportional zur Differenz zwischen dem ersten Verarbeitungssignal und dem Produkt des Schwellenwerts mit dem zweiten Verarbeitungssignal und zum anderen mindestens eine erste elementare Vergleichsoperation umfaßt, die im wesentlichen in Vergleichen der jeweiligen Polaritäten des ersten gemischten Signals (m1) und des zweiten Verarbeitungssignals besteht.

6. Verfahren nach Anspruch 5, dadurch gekennzeichnet, daß die fortgeschrittene Vergleichsoperation weiter zum einen die Erzeugung eines zweiten gemischten Signals (m2) proportional zur Summe des ersten Verarbeitungssignals und des Produkts des Schwellenwerts mit dem zweiten Verarbeitungssignal und zum anderen eine zweite elementare Vergleichsoperation umfaßt, die im wesentlichen im Vergleichen der jeweiligen Polaritäten des zweiten gemischten Signals und des zweiten Verarbeitungssignals besteht.

7. Verfahren nach einem beliebigen der Ansprüche 1 bis 6, angewandt auf den Schutz eines Leitungsstrangs, dessen Länge (T) durch einen Bruchteil der Gesamtlänge (L) der Leitung dargestellt ist und der stromabwärts des Meßpunkts und stromaufwärts eines Schutzgrenzpunkts gelegen ist, dadurch gekennzeichnet, daß der Schwellenwert absolut gesehen im wesentlichen dem Verhältnis einer ersten Größe, dargestellt durch das Einser-Komplement des Bruchteils der Gesamtlänge der Leitung, zu einer zweiten Größe entspricht, die durch den Prozentsatz gebildet wird, den die stromabwärts des Schutzgrenzpunkts gelegene Impedanz zur Gesamtimpedanz der Leitung und ihrer Versorgungsquellen (S, P) ausmacht, an die die Leitung angeschlossen ist.

8. Verfahren nach einem beliebigen der Ansprüche 1 bis 7, dadurch gekennzeichnet, daß es die Erzeugung erster und zweiter Stromübergangssignale (I'w1, I'w2) als Verarbeitungssignale umfaßt, die je in jedem Augenblick der Differenz zwischen dem Wert des entsprechenden Stromsignals in diesem Augenblick und demjenigen Wert proportional ist, den das Stromsignal bei nicht vorhandenem Fehler gehabt hätte.

9. Verfahren nach einem beliebigen der Ansprüche 1 bis 8 kombiniert mit Anspruch 2, dadurch gekennzeichnet, daß sich die Verarbeitungssignale zeitlich in Abhängigkeit von den Momentanwerten des Moduls und des Phasenwinkels der ersten und zweiten Stromsignale verändern und daß die fortgeschrittene Vergleichsoperation in einem Moment durchgeführt wird, in welchem das zweite Verarbeitungssignal einen Extremwert durchläuft.

10. Verfahren nach einem beliebigen der Ansprüche 1 bis 7, dadurch gekennzeichnet, daß es die Erzeugung von skalaren Verarbeitungssignalen (Iw1 - Iw2, Iw1 + Iw2) als erste und zweite Verarbeitungssignale umfaßt, die sich zeitlich nur in Abhängigkeit vom Modul des ersten und zweiten Stromsignals verändern.

11. Verfahren zur Ermittlung, welchem jeweiligen Dreileiterbündel die von Fehlern betroffenen Leiter angehören, wobei sich die Fehler auf mindestens zwei Phasen einer elektrischen Leitung bestehend aus zwei Dreileiterbündeln bemerkbar machen, deren entsprechende Phasen parallelgeschaltet sind, und wobei das Verfahren in der Durchführung eines Verfahrens gemäß irgendeinem der vorhergehenden Ansprüche auf jede gestörte Phase besteht.

12. Einrichtung zur Ermittlung, welcher Mehrphasenleitergruppe ein von einem Fehler betroffener Leiter angehört, wobei sich der Fehler auf einer Phase einer elektrischen Leitung bestehend aus mindestens zwei Mehrphasengruppen bemerkbar macht, die an mindestens ein Ende der Leitung parallelgeschaltet sind, und die wobei Einrichtung

- Kombinationsmittel (3, 5, 6) zur Erzeugung von Verarbeitungssignalen, die durch Kombinationen eines ersten und eines zweiten Stromsignals dargestellt werden, wobei letztere den Momentanwerten der Ströme proportional sind, die in den ersten und zweiten Leitern fließen, und wobei diese Leiter in der ersten bzw. der zweiten Gruppe diejenigen Leiter sind, die der gestörten Phase zugeordnet sind,

- Mittel (7, 8, 9, 10, 11) zur Durchführung einer fortgeschrittenen Vergleichsoperation bestehend aus bzw. äquivalent dem Vergleich einer Asymmetriegröße mit einem Schwellenwert bestimmter Größe, wobei die Asymmetriegröße als Funktion der Verarbeitungssignale ausdrückbar und repräsentativ für die Asymmetrie der Verteilung des Stroms der fehlerhaften Phase zwischen dem ersten und dem zweiten Leiter ist;

- Mittel (12, 13, 14, 15) zur Erzeugung mindestens eines ersten Ausgangssignals aufweist, das den dem Stromsignal mit dem kleineren Modul zugeordneten Leiter als störungsfrei identifiziert, vorausgesetzt, daß die Asymmetriegröße absolut gesehen den festgesetzten Schwellenwert übersteigt, dadurch gekennzeichnet, daß die Asymmetriegröße (R) dem Produkt des Cosinus des Phasenwinkels zwischen der Differenz (Iw1 - Iw2) und der Summe (Iw1 + Iw2) des ersten und zweiten Stromsignals mit dem Verhältnis des Moduls der Differenz dieser Stromsignale zum Modul ihrer Summe proportional ist.

13. Einrichtung nach Anspruch 12, dadurch gekennzeichnet, daß die Mittel zur Erzeugung der Verarbeitungssignale Mittel (5) zur Erzeugung des ersten Verarbeitungssignals als Funktion der Differenz (Iw1 - Iw2) des ersten und des zweiten Stromsignals, und Mittel (6) zur Erzeugung des zweiten Verarbeitungssignals als Funktion der Summe (Iw1 + Iw2) des ersten und des zweiten Stromsignals aufweisen.

FIG.1

RA1   1   a b c   RB1

A   RA2   2   c b a   RB2   B

S   P

X   L-X

T

FIG.2A

Iw2   Iw1-Iw2   $(Iw1+Iw2, 90°)$   Iw1+Iw2   Q(Iw1-Iw2)   Iw1

FIG.2B

-K.(Iw1+Iw2)   +K.(Iw1+Iw2)

Iw1-Iw2+K.(Iw1+Iw2)

Iw1-Iw2

Iw1-Iw2-K.(Iw1+Iw2)

FIG.2C

Iw2   Iw1-Iw2   $(Iw1+Iw2, 90°)$   Iw1+Iw2   Iw1

FIG.2D

-K.(Iw1+Iw2)   K.(Iw1+Iw2)

Iw1-Iw2+K.(Iw1+Iw2)

Iw1-Iw2

Iw1-Iw2-K.(Iw1+Iw2)

FIG. 3

FIG. 4

FIG. 5

EP 0 229 547 B1

FIG. 6

EP 0 229 547 B1